# EUROPÄISCHE PATENTSCHRIFT

(11) **EP 3 748 387 B1**
(45) Veröffentlichungstag und Bekanntmachung des Hinweises auf die Patenterteilung: **07.08.2024**
(21) Anmeldenummer: 19178355.4
(22) Anmeldetag: 05.06.2019
(51) Int. Cl.: G01R 33/565, G01R 33/567

(54) **VERFAHREN ZUR VERBESSERUNG DER QUALITÄT VON MAGNETRESONANZ-BILDERN**
METHOD FOR IMPROVING THE QUALITY OF MAGNETIC RESONANCE IMAGES
PROCÉDÉ D'AMÉLIORATION DE LA QUALITÉ DES IMAGES DE RÉSONANCE MAGNÉTIQUE

(43) Veröffentlichungstag der Anmeldung: 09.12.2020
(73) Patentinhaber: Siemens Healthineers AG, 91301 Forchheim (DE)
(72) Erfinder: Zeller, Mario, 91054 Erlangen (DE)
(74) Vertreter: Siemens Healthineers Patent Attorneys

(56) Entgegenhaltungen:
- EP-A2- 3 214 457
- US-A1- 2012 243 756
- US-B2- 9 655 522

## Beschreibung

Die vorliegende Erfindung betrifft ein Verfahren zur Verbesserung der Qualität von Magnetresonanz-Bildern, eine Magnetresonanzanlage und ein Computerprogrammprodukt zur Ausführung des Verfahrens.

Bei einer Magnetresonanzuntersuchung (MR-Untersuchung) wird häufig ein Untersuchungsobjekt, insbesondere ein Patient oder Tier, einem relativ starken Hauptmagnetfeld, beispielsweise 1,5 oder 3 oder 7 Tesla, ausgesetzt. Dies kann durch eine Positionierung des Untersuchungsobjektes innerhalb eines Aufnahmebereiches einer Magnetresonanzanlage ermöglicht werden. Durch die Positionierung des Untersuchungsobjektes innerhalb des relativ starken Hauptmagnetfeldes kommt es üblicherweise zu einer parallelen oder anti-parallelen Ausrichtung von Kernspins, insbesondere Wasserprotonenspins, zur Richtung des Hauptmagnetfeldes innerhalb des Untersuchungsobjektes. Dabei kommt es zu einer Präzession der Kernspins um die Richtung des Hauptmagnetfeldes herum mit einer Larmorfrequenz. Die Larmorfrequenz ist hierbei abhängig von einer Art der Kerne sowie von der magnetischen Flussdichte des Hauptmagnetfeldes.

Da die parallele Ausrichtung der Kernspins zum Hauptmagnetfeld einen thermischen und energetischen Gleichgewichtszustand darstellt, kommt es häufig zu einer parallelen Ausrichtung einer Netto-Magnetisierung zum Hauptmagnetfeld. Hierbei ergibt sich die Netto-Magnetisierung, im Folgenden auch als Magnetisierung bezeichnet, als effektive makroskopische Magnetisierung der einzelnen magnetischen Dipolmomente der Kernspins.

Mittels einer Gradientenspuleneinheit können zusätzliche und räumlich variierende Magnetfelder, insbesondere Magnetfeld-Gradienten, ausgegeben werden. Durch eine folglich positionsabhängige Larmorfrequenz entlang der räumlichen Dimension der Magnetfeld-Gradienten kann somit eine Ortskodierung innerhalb eines Untersuchungsbereiches ermöglicht werden. Mittels einer Hochfrequenz-Antenneneinheit können Hochfrequenz-Pulse (HF-Pulse), beispielsweise Anregungspulse oder Sättigungspulse, ausgegeben werden. Sofern ein HF-Puls resonant mit der Larmorfrequenz der Kernspins ist, kann eine Anregung, insbesondere Auslenkung, der Kernspins aus einer Gleichgewichtslage heraus erfolgen. Die dabei entstehende transversale Komponente der Präzession der Netto-Magnetisierung um die Richtung des Hauptmagnetfeldes herum kann zu einer Induktion in der HF-Antenneneinheit führen. Dabei nimmt die transversale Komponente der Netto-Magnetisierung insbesondere exponentiell mit einer transversalen Relaxationszeitkonstante ab. Hierbei kann ein MR-Signal, insbesondere ein Free-Induction-Decay (FID), mittels der HF-Antenneneinheit detektiert werden. Zudem erfolgt eine longitudinale Relaxation der Netto-Magnetisierung zurück in den thermischen Gleichgewichtszustand.

Mittels der detektierten MR-Signale, welche insbesondere durch die Ausgabe von Magnetfeld-Gradienten ortskodiert sind, können Magnetresonanz-Bilder (MR-Bilder) des Untersuchungsobjektes rekonstruiert werden.

Werden mehrere MR-Signale nach Ausgabe eines einzelnen Anregungspulses ausgelesen, so kann der zeitliche Verlauf einer Relaxation der Kernspins detektiert werden. Dabei wird die Zeitdauer zwischen der Ausgabe des Anregungspulses und dem Auslesen eines MR-Signals häufig als Echozeit (engl. echo time, TE) bezeichnet.

Häufig wird die Ausgabe mehrerer Gradienten, insbesondere entlang verschiedener räumlicher Dimensionen, und von HF-Pulsen in einer Sequenz zusammengefasst, auch Puls-Sequenz oder MR-Sequenz genannt. Die Sequenzen umfassen dabei häufig auch eine zeitliche Abfolge von Auslesefenstern (Analog-to-Digital Conversion, ADC), innerhalb welcher ein Auslesen von MR-Signalen ermöglicht wird.

Aus dem Stand der Technik ist bekannt, dass bei einer Aufnahme von MR-Bildern häufig Bewegungsartefakte durch eine Bewegung des Untersuchungsobjekts während der Aufnahme entstehen können. Bewegungsartefakte treten häufig bei einer MR-Untersuchung eines Ausschnittes des Untersuchungsobjekts auf, beispielsweise eines Abdomens und/oder eines Brustbereiches und/oder eines Kopfes. Insbesondere bei einer Aufnahme von MR-Bilder mit einer segmentierten Abtastung des k-Raums kann es durch die vergleichsweise lange Messdauer zu Bewegungsartefakten kommen, beispielsweise Inkonsistenzen zwischen den Segmenten im k-Raum. Beispiele für Sequenzarten mit einer segmentierten Abtastung des k-Raums sind:
- segmentierte EPI (Echo Planar Imaging)-Sequenz,
- RESOLVE (Readout Segmentation of Long Variable Echo Trains)
- segmentierte TSE (Turbo Spin Echo)-Sequenz.

Ferner gibt es mehrere bekannte Verfahren zur Verringerung oder Korrektur von Bewegungsartefakten in MR-Bildern. Die bekannten Verfahren können dabei in sensorbasierte Korrekturverfahren, navigatorbasierte Aufnahmeverfahren und getriggerte Aufnahmeverfahren unterschieden werden.

Sensorbasierte Korrekturverfahren umfassen häufig die Erfassung eines Ausschnitts des Untersuchungsobjekts, beispielsweise eines Abdomens und/oder eines Brustbereiches und/oder eines Kopfes, mittels eines Kamerasystems. Der Nachteil solcher Verfahren besteht häufig darin, dass der Ausschnitt des Untersuchungsobjekts während der Aufnahme des MR-Bildes insbesondere zu jeder Zeit vollständig durch das Kamerasystem und/oder Sensorsystem erfassbar sein muss. Aus diesem Grund sind die bekannten sensorbasierten Korrekturverfahren oftmals auf eine Anwendung am Kopf des Untersuchungsobjekts beschränkt. Die Bewegungskorrektur kann bei den bekannten sensorbasierten Verfahren sowohl prospektiv als auch retrospektiv erfolgen.

Getriggerte Aufnahmeverfahren verwenden häufig ein physiologisches Signal, welches insbesondere durch einen Sensor erzeugt wird, um die Ausgabe einzelner Bestandteile einer Puls-Sequenz in Abhängigkeit des physiologischen Signals zu ermöglichen. Dabei kann es nachteilig zu einer Verlängerung der Messdauer zur Aufnahme des MR-Bildes kommen. Die Bewegungskorrektur bei getriggerten Aufnahmeverfahren erfolgt häufig prospektiv.

Ferner gibt es bekannte navigatorbasierte Verfahren zur Bestimmung eines Bewegungszustandes des Untersuchungsobjekts vor einzelnen Abschnitten einer Puls-Sequenz. Die Bewegungskorrektur kann hierbei anhand der während der Aufnahme des MR-Bildes bestimmten Bewegungszustände sowohl prospektiv als auch retrospektiv erfolgen. Jedoch wird durch die Ausgabe eines Navigatormoduls zur Bestimmung des Bewegungszustandes die Messdauer zur Aufnahme des MR-Bildes erhöht.

Verfahren zur retrospektiven Bewegungskorrektur sind beispielsweise aus den Dokumenten US9655522B2, US2012/243756A1 und EP3214457A2 bekannt.

Der Erfindung liegt die Aufgabe zugrunde, ein besonders zuverlässiges Verfahren zur retrospektiven Bewegungskorrektur von MR-Bildern anzugeben.

Gemäß einer ersten Variante des Verfahrens zur Verbesserung der Qualität von Magnetresonanzabbildungen wird diese Aufgabe erfindungsgemäß gelöst durch die Merkmale des Anspruchs 1. Vorteilhaften Ausführungsformen mit zweckmäßigen Weiterbildungen sind Gegenstand der Unteransprüche.

Danach ist vorgesehen, dass k-Raum-Messdaten mehrere k-Raum-Abschnitte umfassend von einem Untersuchungsobjekt mittels einer Magnetresonanzanlage aufgenommen werden. Die k-Raum-Messdaten werden in zumindest zwei k-Raum-Bins jeweils zumindest einen k-Raum-Abschnitt umfassend aufgeteilt. Zudem wird jeweils ein Bin-MR-Bild aus jedem der k-Raum-Bins rekonstruiert. Ferner wird zumindest ein Bewegungskorrekturparameter anhand der rekonstruierten Bin-MR-Bilder bestimmt. Hiernach wird ein MR-Bild mittels des zumindest einen Bewegungskorrekturparameters erzeugt.

Das Erfassen der k-Raum-Messdaten kann insbesondere ein Aufnehmen und/oder Abrufen von k-Raum-Messdaten umfassen. Dabei bedeutet das Aufnehmen von k-Raum-Messdaten eine Messung mittels einer Magnetresonanzanlage. Ferner bedeutet das Abrufen von k-Raum-Messdaten ein Abrufen der k-Raum-Messdaten von einem elektronisch und/oder computerlesbaren Datenträger. Zudem können die k-Raum-Messdaten über eine geeignete Schnittstelle eines zur Ausführung des erfindungsgemäßen Verfahrens ausgebildeten Systems und/oder einer Verarbeitungseinheit empfangen werden. Dabei können die k-Raum-Messdaten vorteilhafterweise vor dem Erfassen, also zu einem früheren Zeitpunkt, mittels einer Magnetresonanzanlage aufgenommen und/oder erzeugt worden sein.

Die k-Raum-Messdaten umfassen vorzugsweise mehrere k-Raum-Abschnitte. Die k-Raum-Messdaten können zweidimensional oder dreidimensional sein. Ferner können die in den k-Raum-Messdaten enthaltenen mehreren k-Raum-Abschnitte jeweils zweidimensional und/oder dreidimensional sein. Mit anderen Worten können die k-Raum-Messdaten sowohl zweidimensionale k-Raum-Abschnitte als auch dreidimensionale k-Raum-Abschnitte umfassen.

Bei der Aufnahme der k-Raum-Messdaten erfolgt idealerweise eine Abtastung des k-Raums entlang einer vorbestimmten Trajektorie. Diese vorbestimmte Trajektorie kann beispielsweise eine kartesische, insbesondere zeilenweise, und/oder eine spiralförmige und/oder eine radiale Abtastung umfassen. Ferner kann eine segmentierte Abtastung des k-Raums erfolgen, in diesem Fall können die k-Raum-Messdaten aus den einzelnen k-Raum-Segmenten zusammengesetzt werden.

Hierbei kann eine Aufteilung der k-Raum-Messdaten in insbesondere bezüglich der k-Raum Abtastung zeitlich separable k-Raum-Abschnitte erfolgen. Dabei sind die k-Raum-Werte innerhalb eines k-Raum-Abschnitts durch eine Abtastung, insbesondere entlang einer gemeinsamen Trajektorie, zusammenhängend aufgenommen worden. Ein k-Raum-Abschnitt kann beispielsweise durch eine oder mehrere, insbesondere aufeinanderfolgende in einem regelmäßigen und/oder unregelmäßigen Abstand zueinander angeordnete, k-Raum-Zeilen und/oder ein k-Raum-Segment umfassen.

Ferner können die mehreren k-Raum-Abschnitte jeweils zu verschiedenen Zeitpunkten mittels der Magnetresonanzanlage aufgenommen worden sein. Die k-Raum-Messdaten werden vorteilhafterweise durch die Gesamtheit der mehreren k-Raum-Abschnitte gebildet.

Gemäß dem vorgeschlagenen Verfahren werden die k-Raum-Messdaten in zumindest zwei k-Raum-Bins aufgeteilt. Ein k-Raum-Bin beschreibt dabei eine Eingruppierung zumindest eines k-Raum-Abschnitts in Abhängigkeit eines vorgegebenen Binning-Kriteriums. Das vorgegebene Binning-Kriterium kann durch eine Bewegungsphase des Untersuchungsobjekts und/oder eine Phase eines physiologischen Signals und/oder eine Phase eines Akquisitionsprotokolls zur Aufnahme der k-Raum-Messdaten umfassen. Sofern ein k-Raum-Abschnitt ein vorgegebenes Binning-Kriterium erfüllt, kann der k-Raum-Abschnitt dem korrespondierenden k-Raum-Bin zugeordnet werden. Somit erfüllen alle einem k-Raum-Bin zugeordneten k-Raum-Abschnitte das jeweilige Binning-Kriterium des k-Raum-Bins. Jeder der k-Raum-Bins kann in Abhängigkeit der Dimensionalität der zugeordneten k-Raum-Abschnitte entweder zweidimensional und/oder dreidimensional sein. Ferner weist jeder der k-Raum-Bins jeweils eine dünnbesetztere (engl. sparse) k-Raum-Abtastung gegenüber den k-Raum-Messdaten auf.

Des Weiteren wird als Teil des vorgeschlagenen Verfahrens jeweils ein Bin-MR-Bild aus jedem der k-Raum-Bins rekonstruiert. Hierbei wird insbesondere durch, insbesondere voxelweise, Anwendung einer inversen Fouriertransformation auf die dem jeweiligen k-Raum-Bin zugeordneten k-Raum-Abschnitte ein Bin-MR-Bild im Bildraum erzeugt.

Dabei können die einzelnen Bin-MR-Bilder in Abhängigkeit der Dimensionalität des zugrundeliegenden k-Raum-Bins jeweils zweidimensional und/oder dreidimensional sein.

Der gemäß dem vorgeschlagenen Verfahren anhand der rekonstruierten Bin-MR-Bilder bestimmte zumindest eine Bewegungskorrekturparameter kann beispielsweise eine Transformationsvorschrift und/oder eine Filterungsinformation zur Korrektur der bestimmten Bewegung umfassen.

Das mittels des zumindest einen Bewegungskorrekturparameters bestimmte MR-Bild stellt vorteilhafterweise eine bewegungskorrigierte MR-Abbildung des Untersuchungsobjekts im Bildraum dar. Dabei erfolgt die Bewegungskorrektur der dem MR-Bild zugrundeliegenden k-Raum-Messdaten anhand des zumindest einen Bewegungskorrekturparameters. Hierdurch kann vorteilhafterweise eine besonders zuverlässige retrospektive Bewegungskorrektur der dem MR-Bild zugrundeliegenden k-Raum-Messdaten ermöglicht werden.

In einer weiteren vorteilhaften Ausführungsform kann mittels des zumindest einen Bewegungskorrekturparameters eine Korrektur des zumindest einen k-Raum-Bins, insbesondere allen k-Raum-Bins, durchgeführt werden. Dabei können die korrigierten k-Raum-Messdaten durch ein Zusammensetzen der korrigierten k-Raum-Bins und der übrigen, insbesondere nicht korrigierten, k-Raum-Bins erzeugt werden. Ferner kann die Erzeugung des MR-Bildes vorteilhafterweise eine Rekonstruktion der korrigierten k-Raum-Messdaten umfassen.

Die Korrektur des zumindest einen k-Raum-Bins kann dabei vorteilhafterweise eine Anwendung einer anhand des zumindest einen Bewegungskorrekturparameters bestimmten Transformationsvorschrift und/oder eine Filterungsinformation auf die dem k-Raum-Bin zugeordneten k-Raum-Abschnitte umfassen. Diese Anwendung kann insbesondere einzeln für jeden der dem k-Raum-Bin zugeordneten k-Raum-Abschnitte oder insgesamt auf alle dem k-Raum-Bin zugeordneten k-Raum-Abschnitte erfolgen.

Ferner kann es vorteilhaft sein, nur eine Teilmenge aller oder alle in den k-Raum-Messdaten enthaltenen k-Raum-Bins zu korrigieren. Es kann beispielsweise vorkommen, dass eine Bewegung nur in einzelnen, insbesondere nicht allen, k-Raum-Bins vorhanden ist und zu korrigieren ist.

Dadurch, dass das zumindest eine k-Raum-Bin bewegungskorrigiert wird, können korrigierte k-Raum-Messdaten durch ein Zusammensetzen des zumindest einen korrigierten k-Raum-Bins und der übrigen, insbesondere nicht korrigierten, k-Raum-Bins erzeugt werden. Sofern alle k-Raum-Bins bewegungskorrigiert werden, können die korrigierten k-Raum-Messdaten durch ein Zusammensetzen aller korrigierten k-Raum-Bins erzeugt werden.

Hierdurch kann vorteilhafterweise erreicht werden, dass die korrigierten k-Raum-Messdaten eine gegenüber den k-Raum-Messdaten gleiche k-Raum-Abtastdichte aufweisen, wie die einzelnen k-Raum-Bins.

Die Erzeugung des MR-Bildes im Bildraum kann vorteilhafterweise eine Rekonstruktion, insbesondere durch voxelweise Anwendung einer inversen Fouriertransformation, auf die korrigierten k-Raum-Messdaten umfassen. Dadurch, dass die korrigierten k-Raum-Messdaten eine gegenüber den k-Raum-Messdaten gleiche k-Raum-Abtastdichte aufweisen, kann eine gegenüber den k-Raum-Messdaten entsprechende räumliche Auflösung im Bildraum erhalten bleiben.

Erfindungsgemäß wird mittels des zumindest einen Bewegungskorrekturparameters eine Korrektur zumindest eines k-Raum-Bins durchgeführt. Hierbei wird jeweils ein korrigiertes Bin-MR-Bild aus jedem der korrigierten k-Raum-Bins rekonstruiert. Ferner wird das MR-Bild vorteilhafterweise aus den korrigierten Bin-MR-Bildern und den übrigen, insbesondere nicht korrigierten, Bin-MR-Bildern erzeugt. Dabei kann die Erzeugung des MR-Bildes aus den korrigierten Bin-MR-Bildern und den übrigen Bin-MR-Bildern eine, insbesondere gewichtete, Mittelung und/ oder Multiplikation umfassen. Vorteilhafterweise kann hierdurch die Anwendung eines Filters im Bildraum der Bin-MR-Bilder vor der Erzeugung des MR-Bildes ermöglicht werden.

Die Vorteile der hier vorgeschlagenen Ausführungsform entsprechen dabei zusätzlich den Vorteilen der vorstehend beschriebenen Ausführungsform zur Korrektur zumindest eines k-Raum-Bins.

In einer weiteren vorteilhaften Ausführungsform kann die Korrektur des zumindest einen k-Raum-Bins eine Anwendung einer, insbesondere linearen, Phasenrampe und/oder einer Rotationstransformation und/oder eine Neurasterung umfassen.

Aus dem Stand der Technik ist bekannt, dass eine translatorische Bewegung des Untersuchungsobjekts während einer MR-Untersuchung häufig zu einer linearen Phasenakkumulation im k-Raum führt. Mittels des zumindest einen Bewegungskorrekturparameters kann vorteilhafterweise eine Erkennung translatorischer Bewegungen des Untersuchungsobjekts erfolgen. Durch Anwendung einer, insbesondere linearen, Phasenrampe auf die k-Raum-Bins, für die eine translatorische Bewegung erfasst wurde, kann die lineare Phasenakkumulation korrigiert werden.

Ferner ist aus dem Stand der Technik bekannt, dass eine Rotationsbewegung des Untersuchungsobjekts auch einer Rotationsbewegung im k-Raum entspricht. Anhand des zumindest einen Bewegungskorrekturparameters kann vorteilhafterweise eine Rotationsbewegung des Untersuchungsobjekts erfasst werden. Durch Anwendung einer der Rotationsbewegung im k-Raum des k-Raum-Bins in welchem eine Rotationsbewegung erfasst wurde, welche insbesondere der erfassten Rotationsbewegung entgegengerichtet ist, kann eine Bewegungskorrektur erfolgen. Hierbei kann eine Anwendung einer Neurasterung des jeweils korrigierten k-Raum-Bins besonders vorteilhaft sein, insbesondere zum Erhalt der räumlichen Auflösung.

In einer weiteren vorteilhaften Ausführungsform kann mittels des zumindest einen Bewegungskorrekturparameters eine Korrektur zumindest eines Bin-MR-Bildes, insbesondere aller Bin-MR-Bilder, durchgeführt werden. Dabei kann das MR-Bild aus den korrigierten Bin-MR-Bildern und den übrigen, insbesondere nicht korrigierten, Bin-MR-Bildern erzeugt werden.

Es kann besonders vorteilhaft sein, nur eine Teilmenge aller oder alle Bin-MR-Bilder zu korrigieren. Es ist beispielsweise möglich, dass eine Bewegung nur in einzelnen, insbesondere nicht allen, Bin-MR-Bildern vorhanden ist. Die Erkennung einer Bewegung in den Bin-MR-Bildern kann mittels des zumindest einen Bewegungskorrekturparameters erfolgen. In diesem Fall kann eine besonders gezielte Bewegungskorrektur im Bildraum des aus dem jeweiligen k-Raum-Bin rekonstruierten Bin-MR-Bildes erfolgen. Die Korrektur kann dabei eine rigide und/ oder nicht-rigide Transformation, beispielsweise eine Rotation und/oder Translation, des zumindest einen Bin-MR-Bildes umfassen. Sofern alle Bin-MR-Bilder korrigiert werden, wird das MR-Bild vorteilhafterweise aus allen korrigierten Bin-MR-Bildern erzeugt.

Die Erzeugung des MR-Bildes aus den korrigierten Bin-MR-Bildern und den übrigen Bin-MR-Bildern kann vorzugsweise eine, insbesondere gewichtete, Mittelung und/oder Multiplikation umfassen. Hierdurch kann vorteilhafterweise die Anwendung eines Filters im Bildraum der Bin-MR-Bilder vor der Erzeugung des MR-Bildes ermöglicht werden.

In einer weiteren vorteilhaften Ausführungsform können korrigierte k-Raum-Messdaten unter Berücksichtigung des zumindest einen Bewegungskorrekturparameters erzeugt werden. Dabei kann die Korrektur der k-Raum-Messdaten insgesamt erfolgen. Ferner kann die Erzeugung des MR-Bildes eine Rekonstruktion der korrigierten k-Raum-Messdaten umfassen.

In der hier vorgeschlagenen Ausführungsform werden die rekonstruierten Bin-MR-Bilder nur zur Bestimmung des zumindest einen Bewegungskorrekturparameters genutzt. Mittels des zumindest einen Bewegungskorrekturparameters kann eine Korrektur der k-Raum-Messdaten insgesamt erfolgen, insbesondere unabhängig von der Aufteilung in die einzelnen k-Raum-Bins.

In einer weiteren vorteilhaften Ausführungsform kann die Korrektur der k-Raum-Messdaten eine Anwendung einer, insbesondere linearen, Phasenrampe und/oder eine Neurasterung umfassen.

Ferner kann die Korrektur eine Anwendung einer Transferfunktion und/oder eines Filters und/oder einer Transformationsvorschrift, beispielsweise einer Rotationsbewegung und/oder einer Translationsbewegung, im k-Raum umfassen.

Vorteilhafterweise kann die zur Korrektur der k-Raum-Messdaten angewandte Transferfunktion und/oder der Filter und/oder die Phasenrampe und/oder die Transformationsvorschrift mittels des zumindest einen Bewegungskorrekturparameters bestimmt und/oder erzeugt werden. Hierbei kann beispielsweise kann eine geeignete Skalierung mittels des zumindest einen Bewegungskorrekturparameters vorteilhaft sein. Durch Anwendung einer Neurasterung kann insbesondere sichergestellt werden, dass eine räumliche Auflösung auch nach Korrektur der k-Raum-Messdaten erhalten bleibt.

In einer weiteren vorteilhaften Ausführungsform kann die Aufteilung der k-Raum-Messdaten in die zumindest zwei k-Raum-Bins in Abhängigkeit einer Phase eines physiologischen Signals erfolgen. Hierdurch kann erreicht werden, dass jedem der k-Raum-Bins jeweils die k-Raum-Abschnitte zugeordnet werden, deren Aufnahmezeitpunkt zur gleichen Phase des physiologischen Signals korrespondiert. Insbesondere wird das Binning-Kriterium zur Zuordnung der k-Raum-Abschnitte in die zumindest zwei k-Raum-Bins durch die Phase des physiologischen Signals gebildet.

Das physiologische Signal des Untersuchungsobjekts kann beispielsweise ein Atemsignal und/oder ein Pulssignal eines Herzens, beispielsweise von einem Pulsoximeter, umfassen. Dabei kann eine Phase des physiologischen Signals einen, insbesondere wiederkehrenden, Zeitabschnitt innerhalb eines zeitlichen Verlaufs des physiologischen Signals umfassen. Die Phase kann beispielsweise einer Phase einer Bewegung des Untersuchungsobjekts entsprechen. Diese kann bei einem Atemsignal des Untersuchungsobjekts beispielsweise durch eine Einatemphase und/oder eine Ausatemphase gebildet werden. Hierdurch kann vorteilhafterweise sichergestellt werden, dass jedes der zumindest zwei k-Raum-Bins einer bestimmten Phase der Bewegung des Untersuchungsobjekts entspricht.

In einer weiteren vorteilhaften Ausführungsform kann zu jedem der rekonstruierten Bin-MR-Bilder jeweils zumindest ein Bewegungskorrekturparameter bestimmt werden. Hierdurch kann eine besonders spezifische und genaue Erfassung der Bewegung des Untersuchungsobjekts für jedes der Bin-MR-Bilder ermöglicht werden. Insbesondere bei einer Korrektur einzelner k-Raum-Bins oder einzelner Bin-MR-Bilder kann durch den jeweils zumindest einen Bewegungskorrekturparameter eine besonders hohe Genauigkeit erreicht werden.

In einer weiteren vorteilhaften Ausführungsform kann ein Bewegungssignal anhand der mehreren Bewegungskorrekturparameter bestimmt werden. Dadurch, dass jeder der mehreren Bewegungskorrekturparameter anhand eines Bin-MR-Bildes bestimmt wurde, können die mehreren Bewegungskorrekturparameter jeweils einem der Binning-Kriterien zugeordnet werden. Die Aufteilung der k-Raum-Messdaten in die zumindest zwei k-Raum-Bins kann vorteilhafterweise in Abhängigkeit einer zeitlichen Abfolge der Aufnahme, der den k-Raum-Bins zuzuordnenden k-Raum-Abschnitte, erfolgen. Dabei kann jedem Aufnahmezeitpunkt eines k-Raum-Abschnitts ein Bewegungskorrekturparameter zugeordnet werden, der anhand des aus dem korrespondierenden k-Raum-Bin rekonstruierten Bin-MR-Bildes bestimmt wurde. Das Bewegungssignal kann durch den zeitlichen Verlauf der den Aufnahmezeitpunkten zugeordneten Bewegungskorrekturparameter gebildet werden. Dabei kann das Bewegungssignal beispielsweise einem physiologischen Signal des Untersuchungsobjekts entsprechen, beispielsweise einem Atemsignal und/oder eine Pulssignal des Herzens.

In einer weiteren vorteilhaften Ausführungsform kann der zumindest eine Bewegungskorrekturparameter mittels einer Registrierung der rekonstruierten Bin-MR-Bilder zueinander bestimmt werden. Eine translatorische Bewegung des Untersuchungsobjekts wird häufig in eine translatorische Bewegung einer MR-Abbildung des Untersuchungsobjekts im Bildraum übersetzt. Auch bei einer Rotationsbewegung des Untersuchungsobjekts kommt es häufig zu einer Rotationsbewegung der MR-Abbildung des Untersuchungsobjekts im Bildraum. Oftmals liegt eine aus verschiedenen Teilbewegungen zusammengesetzte Bewegung des Untersuchungsobjekts vor. Insbesondere bei physiologisch bedingten Bewegungen, beispielsweise bei einer Atembewegung und/oder einer Bewegung des Herzens, kann in wiederkehrende Phasen der Bewegung unterschieden werden. Innerhalb einer Phase der Bewegung liegt häufig die gleiche oder eine zumindest gleichgerichtete Bewegung des Untersuchungsobjekts vor.

Dadurch, dass mittels des Binning-Kriteriums jedes der rekonstruierten Bin-MR-Bilder vorzugsweise jeweils einer Phase der Bewegung des Untersuchungsobjekts zugeordnet ist, kann durch eine Registrierung der Bin-MR-Bilder zueinander eine Bewegung des Untersuchungsobjekts, insbesondere an den Übergängen, zwischen den Phasen der Bewegung erfasst werden. Hierdurch kann eine besonders zuverlässige und genaue Bewegungskorrektur ermöglicht werden.

In einer weiteren vorteilhaften Ausführungsform kann die Rekonstruktion der Bin-MR-Bilder aus jedem der k-Raum-Bins eine Anwendung eines Verfahrens zur Rekonstruktion dünnbesetzter (engl. sparse) k-Raum-Abtastungen umfassen. Bei der Aufteilung der k-Raum-Messdaten in die zumindest zwei k-Raum-Bins kann es vorkommen, dass einzelne oder alle der k-Raum-Bins eine dünnbesetzte (engl. sparse) Abtastung aufweisen und insbesondere das Nyquist-Shannon-Abtasttheorem nicht erfüllen. Zur Rekonstruktion der Bin-MR-Bilder aus diesen dünnbesetzt abgetasteten k-Raum-Bins können vorteilhafterweise bekannte Verfahren der komprimierten Erfassung (engl. compressed sensing) oder ein faltendes neuronales Netz (engl. convolutional neural network, CNN) angewandt werden.

Sofern die HF-Antenneneinheit mehrere Empfangsspulen umfasst, beispielsweise innerhalb einer Lokalspuleneinheit, kann die Aufnahme der k-Raum-Messdaten ein paralleles Bildgebungsverfahren umfassen. Hierbei können die k-Raum-Messdaten insbesondere mehrere k-Raum-Abschnitte von jeweils einer der mehreren Empfangsspulen umfassen. Hierdurch können, insbesondere in Abhängigkeit des Binning-Kriteriums, Zuordnungen von k-Raum-Abschnitten zu den k-Raum-Bins entstehen, wobei der jeweilige k-Raum-Bin eine dünnbesetzte und/oder ungleichmäßige Abtastung des k-Raums aufweist.

Durch Anwendung bekannter Verfahren zur Rekonstruktion mittels paralleler Bildgebungsverfahren aufgenommener k-Raum-Messdaten, beispielsweise "Generalized Autocalibrating Partially Parallel Acquisitions" (GRAPPA), können die Bin-MR-Bilder aus den k-Raum-Bins, insbesondere unter Berücksichtigung der dünnbesetzten und/oder ungleichmäßigen Abtastung des k-Raums, besonders vorteilhaft rekonstruiert werden.

In einer weiteren vorteilhaften Ausführungsform können die k-Raum-Messdaten in eine Anzahl an k-Raum-Bins aufgeteilt werden, wobei die Anzahl in Abhängigkeit einer räumlichen Auflösung und/oder eines Akquisitionsprotokolls und/oder einer Navigatormessung bestimmt wird.

Bei einer vorgegebenen räumlichen Auflösung, insbesondere jeweils entlang einer bestimmten k-Raum-Dimension, beispielsweise entlang einer Ausleserichtung und/oder Phasenkodierrichtung und/oder Schichtkodierrichtung, kann eine gleichmäßige Aufteilung entlang der jeweils vorbestimmten k-Raum-Dimension in k-Raum-Bins besonders vorteilhaft sein. Dies kann dadurch erreicht werden, dass die Anzahl der k-Raum-Bins entlang einer oder mehrerer k-Raum-Dimensionen mit jeweils vorgegebener räumlicher Dimension, beispielsweise derart bestimmt wird, dass die jeweils vorgegebene räumliche k-Raum-Dimension ein ganzzahliges Vielfaches der Anzahl an k-Raum-Bins ist.

Ein Akquisitionsprotokoll kann insbesondere eine zeitliche Abfolge und räumliche Trajektorie bei der Abtastung des k-Raumes vorgeben. Hierdurch kann eine zeitliche Reihenfolge der Aufnahme der einzelnen k-Raum-Abschnitte, welche insbesondere in Abhängigkeit des Binning-Kriteriums den zumindest zwei k-Raum-Bins zugeordnet werden, vorgegeben werden. Ferner kann das Akquisitionsprotokoll beispielsweise eine Vorschrift zur segmentierten Abtastung des k-Raums umfassen. Hierbei kann es besonders vorteilhaft sein, die Anzahl der k-Raum-Bins in Abhängigkeit des Akquisitionsprotokolls zu bestimmen, also beispielsweise mittels der Vorschrift zur segmentierten Abtastung des k-Raums.

Eine Navigatormessung kann vor und/oder während und/oder nach der Aufnahme der k-Raum-Messdaten erfolgen. Dabei kann die Navigatormessung eine Erfassung eines, insbesondere wiederkehrenden, Bewegungssignals von dem Untersuchungsobjekt umfassen. Das Bewegungssignal kann hierbei insbesondere einem physiologischen Signal entsprechen, beispielsweise einem Atemsignal und/oder Pulssignal des Herzens des Untersuchungsobjekts. Gegenüber dem Stand der Technik wird das anhand der Navigatormessung bestimmte Bewegungssignal nicht zur Korrektur der k-Raum-Messdaten verwendet, sondern zur Bestimmung der Anzahl an k-Raum-Bins. Anhand des Bewegungssignals können zumindest zwei Phasen der Bewegung des Untersuchungsobjekts, beispielsweise eine Einatemphase und eine Ausatemphase, identifiziert werden. Unter der Annahme, dass die erfasste Bewegung eine zumindest teilweise, insbesondere phasenweise, wiederkehrende Bewegung des Untersuchungsobjekts abbildet, kann die Anzahl der k-Raum-Bins mittels der identifizierten Phasen der Bewegung des Untersuchungsobjekts besonders vorteilhaft bestimmt werden. Dadurch, dass das vorgeschlagene Verfahren retrospektiv auf die erfassten k-Raum-Messdaten angewandt wird, kann die Navigatormessung insbesondere zeitlich getrennt von der Aufnahme der k-Raum-Messdaten erfolgen. Eine Navigatormessung zur Bestimmung eines Bewegungssignals des Untersuchungsobjekts kann beispielweise eine wiederholte Abtastung einer Zentrallinie des k-Raums umfassen.

Ferner wird eine Magnetresonanzanlage vorgeschlagen, die ausgebildet ist, eine Ausführungsform des vorgeschlagenen Verfahrens auszuführen, wobei die Magnetresonanzanlage eine HF-Verarbeitungseinheit, eine Gradientensteuereinheit, eine Sequenzsteuereinheit und eine Verarbeitungseinheit umfasst. Dabei ist die Magnetresonanzanlage dazu ausgebildet, um mittels der HF-Verarbeitungseinheit, der Gradientensteuereinheit, der Sequenzsteuereinheit und der Verarbeitungseinheit ein MR-Bild zu erzeugen.

Hierfür kann die Magnetresonanzanlage beispielsweise mittels der Sequenzsteuereinheit eine Sequenz zur Aufnahme von k-Raum-Messdaten mehrere k-Raum-Abschnitte umfassend vorgeben. Ferner kann die Sequenz eine Ausgabe von HF-Pulsen umfassen, insbesondere Anregungspulsen und/oder Sättigungspulsen, wobei die HF-Pulse mittels der HF-Verarbeitungseinheit ausgegeben werden können. Zudem kann die Sequenz eine Ausgabe von Magnetfeldgradienten umfassen, beispielsweise Lesegradienten und/oder Phasenkodiergradienten und/oder Schichtkodiergradienten und/oder Spoilergradienten, wobei die Magnetfeldgradienten mittels der Gradientensteuereinheit ausgegeben werden können. Dabei kann die Sequenz insbesondere eine Abtastung des k-Raums vorgeben. Die HF-Verarbeitungseinheit kann weiterhin dazu ausgebildet sein, die k-Raum-Messdaten mehrere k-Raum-Abschnitte umfassend zu erfassen und insbesondere der Verarbeitungseinheit bereitzustellen.

In einer weiteren vorteilhaften Ausführungsform können die k-Raum-Messdaten zu einem früheren Zeitpunkt aufgenommen worden sein. Hierbei kann Verarbeitungseinheit der Magnetresonanzanlage ein Abrufen der k-Raum-Messdaten mehrere k-Raum-Abschnitte umfassend ermöglichen, beispielweise mittels eines elektronisch und/oder computerlesbaren Datenträgers.

In den vorgeschlagenen Ausführungsformen der Magnetresonanzanlage erfolgt eine Bereitstellung der k-Raum-Messdaten an die Verarbeitungseinheit entweder durch eine Aufnahme und/ oder ein Abrufen der k-Raum-Messdaten. Die Verarbeitungseinheit kann zudem dazu ausgebildet sein, die k-Raum-Messdaten in zumindest zwei k-Raum-Bins jeweils zumindest einen k-Raum-Abschnitt umfassend aufzuteilen. Ferner kann die Verarbeitungseinheit zur Rekonstruktion jeweils eines Bin-MR-Bildes aus jedem der k-Raum-Bins ausgebildet sein. Zudem kann die Verarbeitungseinheit dazu ausgebildet sein, zumindest einen Bewegungskorrekturparameter anhand der rekonstruierten Bin-MR-Bilder zu bestimmen. Des Weiteren kann die Verarbeitungseinheit dazu ausgebildet sein, ein MR-Bild mittels des zumindest einen Bewegungskorrekturparameters zu erzeugen.

Ferner kann die Magnetresonanzanlage eine Darstellungseinheit, beispielsweise ein Display und/oder Monitor und/oder eine LED-Anzeige, umfassen, welche dazu ausgebildet ist, Informationen und/oder graphische Darstellungen von Informationen der Magnetresonanzanlage und/oder von weiteren Komponenten der Magnetresonanzanlage und/oder ein MR-Bild anzuzeigen.

Die Vorteile der vorgeschlagenen Magnetresonanzanlage entsprechen im Wesentlichen den Vorteilen des vorgeschlagenen Verfahrens zur Verbesserung der Qualität von MR-Bildern. Hierbei erwähnte Merkmale, Vorteile oder alternative Ausführungsformen können ebenso auch auf die anderen beanspruchten Gegenstände übertragen werden und umgekehrt.

Ferner wird ein Computerprogrammprodukt vorgeschlagen, das ein Programm umfasst und direkt in einen Speicher einer programmierbaren Recheneinheit ladbar ist und Programmmittel, z.B. Bibliotheken und Hilfsfunktionen, aufweist, um ein Verfahren zur Verbesserung der Qualität von MR-Bildern auszuführen, wenn das Computerprogrammprodukt ausgeführt wird. Das Computerprogrammprodukt kann dabei eine Software mit einem Quellcode, der noch kompiliert und gebunden oder der nur interpretiert werden muss, oder einen ausführbaren Softwarecode umfassen, der zur Ausführung nur noch in die Verarbeitungseinheit zu laden ist. Durch das Computerprogrammprodukt kann das Verfahren zur Verbesserung der Qualität von MR-Bildern schnell, identisch wiederholbar und robust ausgeführt werden. Das Computerprogrammprodukt ist so konfiguriert, dass es mittels der Verarbeitungseinheit einer Magnetresonanzanlage die erfindungsgemäßen Verfahrensschritte ausführen kann. Die Verarbeitungseinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können.

Das Computerprogrammprodukt ist beispielsweise auf einem computerlesbaren Medium gespeichert oder auf einem Netzwerk oder Server hinterlegt, von wo es in den Prozessor einer Verarbeitungseinheit geladen werden kann, der mit der Verarbeitungseinheit direkt verbunden oder als Teil der Verarbeitungseinheit ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Verarbeitungseinheit einer Magnetresonanzanlage ein erfindungsgemäßes Verfahren durchführen. Beispiele für elektronisch lesbare Datenträger sind eine DVD, ein Magnetband oder ein USB-Stick, auf welchem elektronisch lesbare Steuerinformationen, insbesondere Software, gespeichert ist. Wenn diese Steuerinformationen von dem Datenträger gelesen und in eine Verarbeitungseinheit gespeichert werden, können alle erfindungsgemäßen Ausführungsformen der vorab beschriebenen Verfahren durchgeführt werden. So kann die Erfindung auch von dem besagten computerlesbaren Medium und/oder dem besagten elektronisch lesbaren Datenträger ausgehen.

Ausführungsbeispiele zu einem Verfahren zur Verbesserung der Qualität von Magnetresonanz-Bildern, einer Magnetresonanzanlage und einem Computerprogrammprodukt zur Ausführung des Verfahrens sind in den Zeichnungen dargestellt und werden im Folgenden näher beschrieben. In unterschiedlichen Figuren werden für gleiche Merkmale die gleichen Bezugszeichen verwendet. Es zeigen
- Fig. 1: eine schematische Darstellung einer Magnetresonanzanlage welche zur Ausführung eines vorgeschlagenen Verfahrens ausgebildet ist;
- Fig. 2 bis 6: jeweils eine schematische Darstellung verschiedener Verfahren zur Verbesserung der Qualität von MR-Bildern, wobei in Fig. 5 das erfindungsgemäße Verfahren dargestellt ist;
- Fig. 7: eine schematische Darstellung einer Ausführungsform eines erfindungsgemäßen Verfahrens mit einer Veranschaulichung einer Aufteilung von k-Raum-Messdaten in k-Raum-Bins;
- Fig. 8: eine schematische Darstellung einer Ausführungsform eines erfindungsgemäßen Verfahrens mit einer Veranschaulichung der Aufteilung von k-Raum-Messdaten in k-Raum-Bins, wobei die Aufteilung in Abhängigkeit eines physiologischen Signals erfolgt;
- Fig. 9: eine schematische Darstellung einer Ausführungsform eines Verfahrens mit einer Veranschaulichung der Aufteilung von k-Raum-Messdaten in k-Raum-Bins.

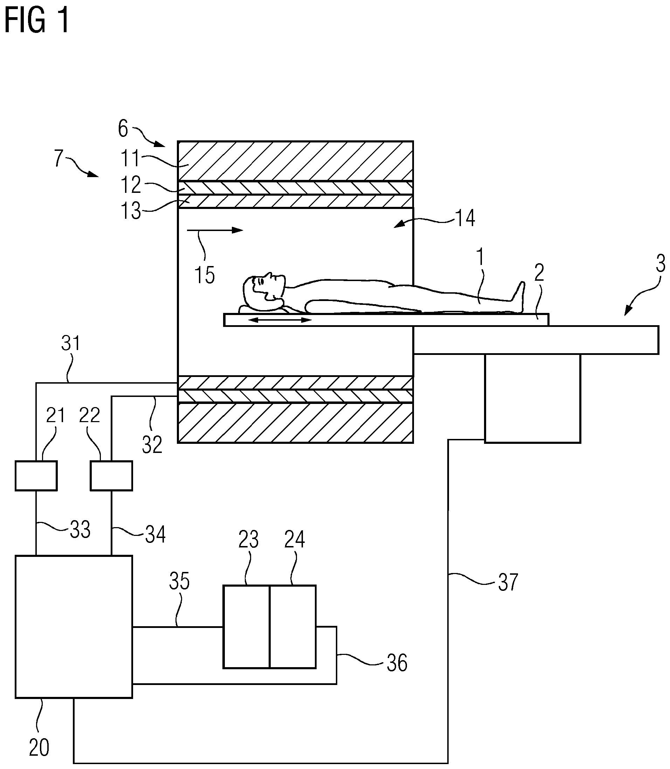

In Fig. 1 ist eine Variante einer Magnetresonanzanlage 7 zur Durchführung eines vorgeschlagenen Verfahrens schematisch dargestellt. Dabei umfasst die Magnetresonanzanlage 7 eine Magneteinheit 6 und einen Untersuchungsbereich 14. Die Magneteinheit 6 umfasst hier ferner einen supraleitenden Grundmagneten 11, welcher ausgebildet ist, ein starkes Grundmagnetfeld 15 mit einer zeitlich konstanten Grundmagnetfeldstärke zu erzeugen. Insbesondere kann der Untersuchungsbereich 14 eine Zylinderform aufweisen, wobei der Untersuchungsbereich 14 von der Magneteinheit 6 entlang einer Mantelfläche des Zylinders umschlossen werden kann. Dabei weist der Untersuchungsbereich 14 zumindest eine Öffnung zur Aufnahme eines Untersuchungsobjektes 1 und einer Lagerungseinrichtung 2 auf. Die Lagerungseinrichtung 2 ist beweglich gelagert, sodass eine Positionierung des Untersuchungsobjektes 1 von einer Position außerhalb der Magnetresonanzanlage 7 in den Untersuchungsbereich 14 hinein erfolgen kann. Hierbei kann die Lagerungseinrichtung 2 von einem Lagerungstisch 3 gestützt und, insbesondere motorisiert und/oder automatisch, bewegt werden. Hierfür kann eine Verarbeitungseinheit 20 ein Signal 37 an den Lagerungstisch 3 senden. Umgekehrt, kann eine Abfrage der aktuellen Positionierung des Untersuchungsobjektes 1 über die Abfrage eines Signals 37 durch die Verarbeitungseinheit 20 vom Lagerungstisch 3 erfolgen.

Des Weiteren umfasst die Magneteinheit 6 eine Gradientenspulenvorrichtung 12, die dazu ausgebildet ist, Magnetfeld-Gradienten, insbesondere Lesegradienten und/oder Phasenkodiergradienten und/oder Schichtkodiergradienten, zur Ortskodierung bei einer Bildaufnahme zu erzeugen. Eine Steuerung der Gradientenspulenvorrichtung 12 kann mittels eines Gradientensteuereinheit 22 erfolgen. Hierfür kann die Gradientensteuereinheit 22 einen variablen Strom 32 in die Gradientenspulenvorrichtung 12 einspeisen.

Die Magneteinheit 6 weist zudem eine HF-Antenneneinheit 13 auf, welche im vorgeschlagenen Ausführungsbeispiel als Körperspule ausgebildet ist. Dabei ist die HF-Antenneneinheit 13 fest in die Magneteinheit 6 integriert und umgibt den Untersuchungsbereich 14. Die HF-Antenneneinheit 13 ist dazu ausgebildet, eine Magnetisierung auszulenken. Die Magnetisierung kommt als eine Netto-Magnetisierung zustande, wobei es in einem Gleichgewichtszustand zu einer parallelen Ausrichtung von Protonenspins im Grundmagnetfeld 15 kommt. Insbesondere kann eine Anregung der Polarisation durch Ausgabe von Anregungspulsen und/oder Refokussierungspulsen erfolgen. Ferner kann die HF-Antenneneinheit 13 durch ein Signal 31 von einer HF-Verarbeitungseinheit 21 gesteuert werden.

Die HF-Antenneneinheit 13 ist ferner dazu ausgebildet, MR-Signale zu empfangen. Hierbei kann die HF-Antenneneinheit ein entsprechendes Signal 31 an die HF-Verarbeitungseinheit 21 senden.

Die Steuerung der Gradientensteuereinheit 22, der HF-Verarbeitungseinheit 21 und des Grundmagneten 6 kann insbesondere über eine Verarbeitungseinheit 20 der Magnetresonanzanlage 7 erfolgen. Hierfür können beispielsweise die Signale 33 und 34 bidirektional genutzt werden.

Die Verarbeitungseinheit 20 kann vorteilhafterweise eine Sequenzsteuereinheit umfassen und dazu ausgebildet sein, eine Sequenz, beispielsweise zur Aufnahme von k-Raum-Messdaten, in Signale für die jeweiligen Komponenten der Magnetresonanzanlage 7 zu übersetzen. Hierdurch kann das Durchführen einer Sequenz bei einer MR-Untersuchung ermöglicht werden. Ferner ist die Verarbeitungseinheit 20 dazu ausgebildet, die von der HF-Antenneneinheit 13 empfangenen MR-Signale zu verarbeiten und daraus ein MR-Bild zu erzeugen.

Des Weiteren umfasst die vorgeschlagene Magnetresonanzanlage 7 eine Darstellungseinheit 23, welche ausgebildet ist, Parameterwerte einer Sequenz und/oder MR-Bilder darzustellen. Hierfür kann die Verarbeitungseinheit 20 ein Signal 35 an die Darstellungseinheit 23 senden. Die Darstellungseinheit 23 kann dabei als Monitor und/oder Display ausgebildet sein. Ferner kann die Magnetresonanzanlage 7 eine Eingabeeinheit 24, beispielsweise eine Tastatur und/oder ein Touchscreen und/oder eine Knopfanordnung, umfassen, die dazu ausgebildet ist, eine Eingabe eines Bedienpersonals durch ein Signal 36 an die Verarbeitungseinheit 20 zu senden.

Eine Steuerung der Lagerungseinrichtung 2 kann ebenfalls über eine Eingabe eines Bedienpersonals an der Eingabeeinheit 24 ermöglicht werden. Hierbei kann die Verarbeitungseinheit 20 ein Signal 37 an den Lagerungstisch 3 senden, wodurch eine automatische und/oder halb-automatische Positionierung des Untersuchungsobjektes 1 relativ zu einem Iso-Zentrum der Magnetresonanzanlage 7 ermöglicht wird.

Die vorgeschlagene Magnetresonanzanlage 7 kann beispielsweise mittels der Sequenzsteuereinheit eine Sequenz zur Aufnahme von k-Raum-Messdaten 41 mehrere k-Raum-Abschnitte 60 umfassend vorgeben. Ferner kann die Sequenz eine Ausgabe von HF-Pulsen umfassen, insbesondere Anregungspulsen und/oder Sättigungspulsen, wobei die HF-Pulse mittels eines Signals 31 der HF-Verarbeitungseinheit 21 von der HF-Antenneneinheit 13 ausgegeben werden können. Zudem kann die Sequenz eine Ausgabe von Magnetfeldgradienten umfassen, beispielsweise Lesegradienten und/oder Phasenkodiergradienten und/oder Schichtkodiergradienten und/oder Spoilergradienten, wobei die Magnetfeldgradienten mittels eines Signals 32 der Gradientensteuereinheit 22 von der Gradientenspulenvorrichtung 12 ausgegeben werden können. Die HF-Verarbeitungseinheit 21 kann weiterhin dazu ausgebildet sein, die k-Raum-Messdaten 41 mittels des Signals 31 von der HF-Antenneneinheit 13 zu erfassen und insbesondere der Verarbeitungseinheit 20 mittels des Signals 33 bereitzustellen.

Des Weiteren können die k-Raum-Messdaten 41 zu einem früheren Zeitpunkt aufgenommen worden sein. Hierbei kann Verarbeitungseinheit 20 der Magnetresonanzanlage ein Abrufen der k-Raum-Messdaten 41 ermöglichen, beispielweise mittels eines elektronisch und/oder computerlesbaren Datenträgers (hier nicht gezeigt).

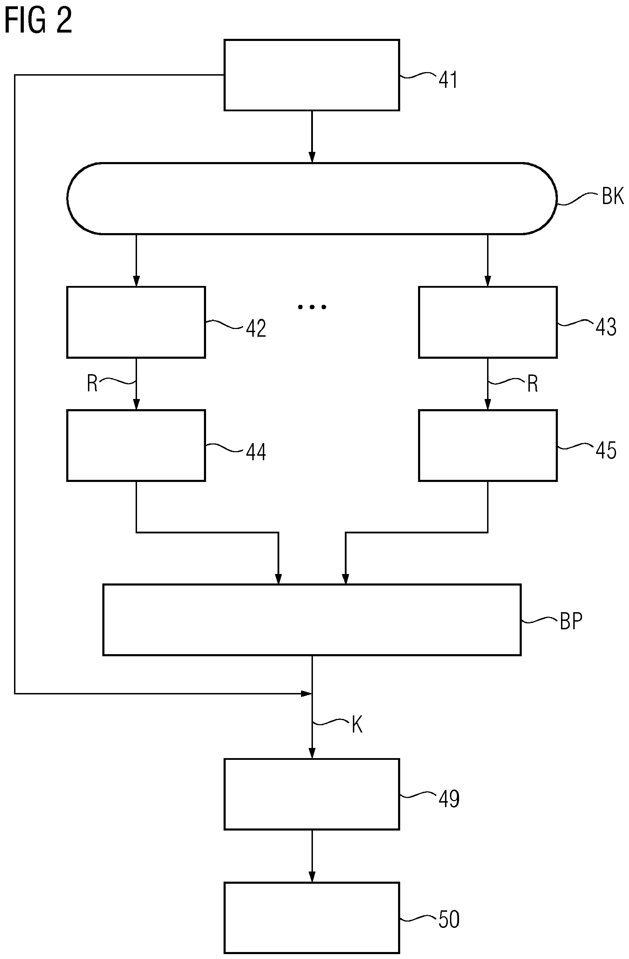

Fig. 2 zeigt eine schematische Darstellung einer Ausführungsform des vorgeschlagenen Verfahrens. Dabei können k-Raum-Messdaten 41 mehrere k-Raum-Abschnitte umfassend (hier nicht gezeigt) von einem Untersuchungsobjekt 1 mittels einer Magnetresonanzanlage 7 erfasst werden. Insbesondere in Abhängigkeit eines Binning-Kriteriums BK kann eine Aufteilung der k-Raum-Messdaten 41 in zumindest zwei k-Raum-Bins 42 und 43 jeweils zumindest einen k-Raum-Abschnitt umfassend erfolgen. Insbesondere alle Schritte des vorgeschlagenen Verfahrens, die auf die Erfassung der k-Raum-Messdaten 41 folgen, können mittels der Verarbeitungseinheit 20 der Magnetresonanzanlage 7 ausgeführt werden.

Vorteilhafterweise kann eine Anzahl an k-Raum-Bins, in welche die k-Raum-Messdaten 41 aufgeteilt werden, insbesondere in Abhängigkeit einer räumlichen Auflösung und/oder eines Akquisitionsprotokolls und/oder einer Navigatormessung bestimmt werden.

Hiernach kann jeweils ein Bin-MR-Bild 44 und 45 aus jedem der k-Raum-Bins 42 und 43 rekonstruiert werden. Dabei kann die Rekonstruktion der Bin-MR-Bilder 44 und 45 aus jedem der k-Raum-Bins 42 und 43 eine Anwendung eines Verfahrens zur Rekonstruktion R dünnbesetzter (engl. sparse) k-Raum-Abtastungen umfassen.

Anhand der rekonstruierten Bin-MR-Bilder 44 und 45 kann zumindest ein Bewegungskorrekturparameter BP bestimmt werden. Des Weiteren kann ein MR-Bild 50 mittels des zumindest einen Bewegungskorrekturparameters BP erzeugt werden. Die erfassten k-Raum-Messdaten 41 können zweidimensional oder dreidimensional sein. Ferner können die zumindest zwei k-Raum-Bins 42 und 43 jeweils zweidimensional und/oder dreidimensional sein, insbesondere in Abhängigkeit des Binning-Kriteriums und/oder der Dimensionalität der zugeordneten k-Raum-Abschnitte (hier nicht gezeigt). Die Dimensionalität der korrigierten k-Raum-Messdaten 49 und des erzeugten MR-Bildes 50 entspricht vorzugsweise der Dimensionalität der k-Raum-Messdaten 41.

In der in Fig. 2 dargestellten Variante des vorgeschlagenen Verfahrens können korrigierte k-Raum-Messdaten 49 unter Berücksichtigung des zumindest einen Bewegungskorrekturparameters BP erzeugt werden. Dabei kann die Korrektur K der k-Raum-Messdaten 41 insgesamt erfolgen, insbesondere unabhängig von der Aufteilung in die einzelnen k-Raum-Bins 42 und 43. Im Anschluss kann das MR-Bild 50 aus den korrigierten k-Raum-Messdaten 49 rekonstruiert werden. Ferner kann die Korrektur K der k-Raum-Messdaten 41 eine Anwendung einer, insbesondere linearen, Phasenrampe und/oder eine Neurasterung umfassen.

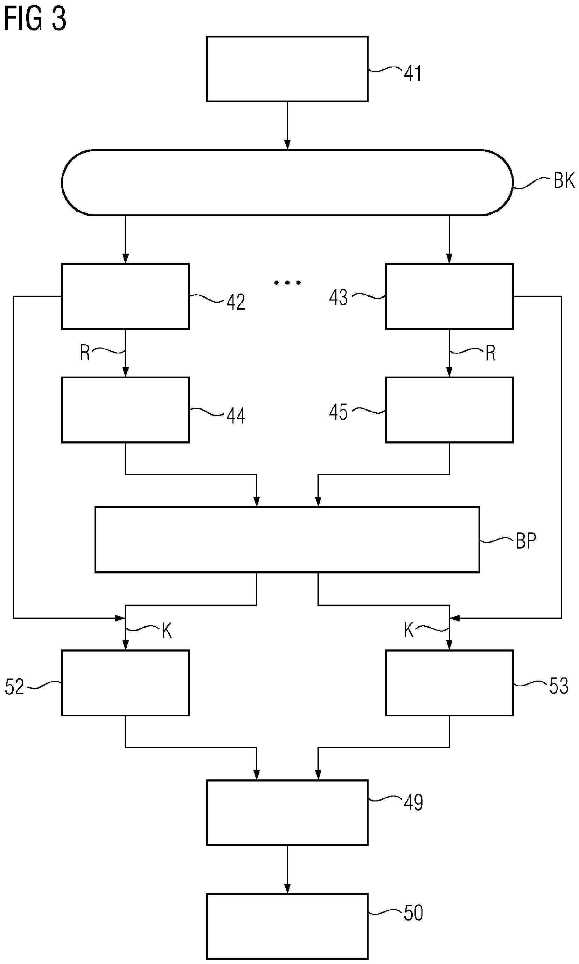

In Fig. 3 ist eine weitere Ausführungsform des vorgeschlagenen Verfahrens schematisch dargestellt. Der Ablauf des vorgeschlagenen Verfahrens ist dabei bis zur Bestimmung des zumindest einen Bewegungskorrekturparameters BP analog zur in Fig. 2 dargestellten Ausführungsform. In der in Fig. 3 abgebildeten Ausführungsform wird ein Bewegungskorrekturparameter BP anhand der Bin-MR-Bilder 44 und 45 bestimmt. Mittels des Bewegungskorrekturparameters BP kann anschließend eine Korrektur K der k-Raum-Bins 42 und 43 durchgeführt werden. Dabei können korrigierte k-Raum-Messdaten 49 durch ein Zusammensetzen der mittels des Bewegungskorrekturparameters BP korrigierten k-Raum-Bins 52 und 53 erzeugt werden. Ferner kann die Erzeugung des MR-Bildes 50 eine Rekonstruktion der korrigierten k-Raum-Messdaten 49 umfassen.

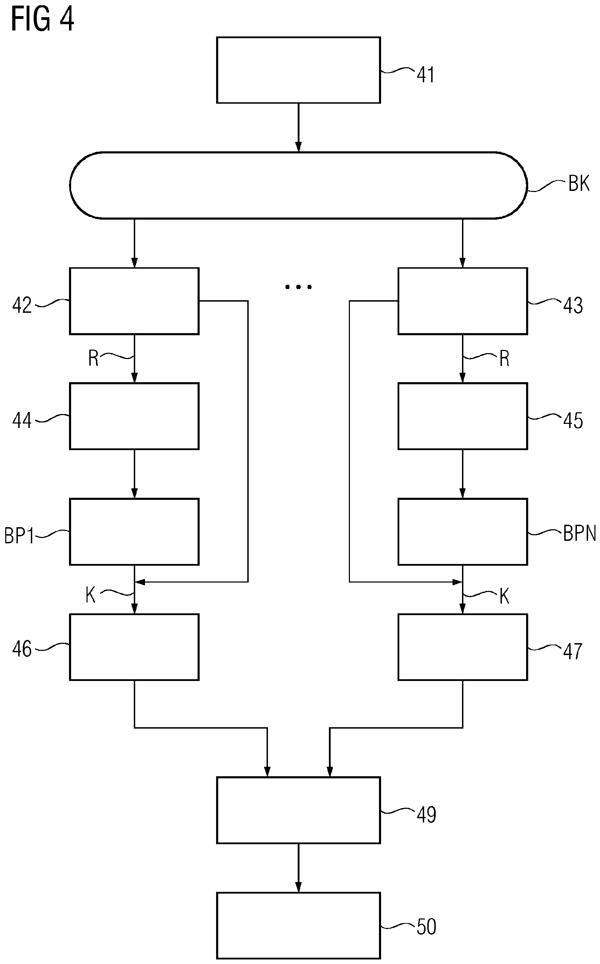

Fig. 4 zeigt eine schematische Darstellung einer weiteren Ausführungsform des vorgeschlagenen Verfahrens, wobei zu jedem der rekonstruierten Bin-MR-Bilder 44 und 45 jeweils zumindest ein Bewegungskorrekturparameter BP1 und BPN bestimmt wird. Dabei kann vorteilhafterweise eine Korrektur K zumindest eines, insbesondere aller, k-Raum-Bins 42 und 43 mittels des jeweils zumindest einen Bewegungskorrekturparameters BP1 und BPN durchgeführt werden. Die dabei erzeugten korrigierten k-Raum-Bins 46 und 47 können anschließend zu den korrigierten k-Raum-Messdaten 49 zusammengesetzt werden. Sofern nur eine Teilmenge aller k-Raum-Bins bewegungskorrigiert wird, können die korrigierten k-Raum-Messdaten 49 aus den korrigierten k-Raum-Bins 46 und 47 und den übrigen, insbesondere nicht korrigierten, k-Raum-Bins (hier nicht gezeigt) zusammengesetzt werden. Die Erzeugung des MR-Bildes 50 kann zudem eine Rekonstruktion der korrigierten k-Raum-Messdaten 49 umfassen.

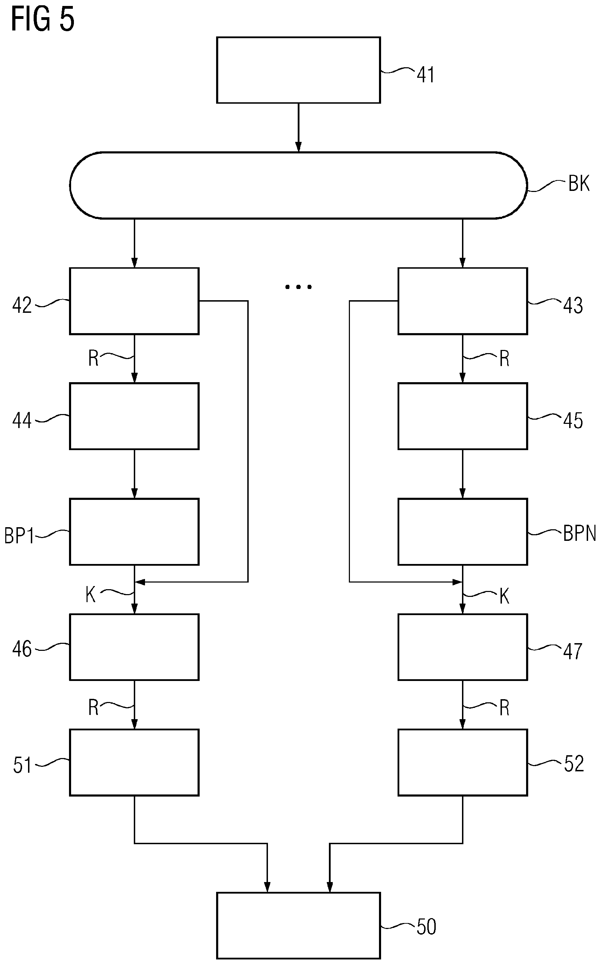

In der in Fig. 5 schematisch dargestellten erfindungsgemäßen Ausführungsform des vorgeschlagenen Verfahrens kann, insbesondere analog zur in Fig. 4 dargestellten Variante, zu jedem der rekonstruierten Bin-MR-Bilder 44 und 45 jeweils zumindest ein Bewegungskorrekturparameter BP1 und BPN bestimmt werden. Zudem kann mittels des jeweils zumindest einen Bewegungskorrekturparameters BP1 und BPN eine Korrektur K der k-Raum-Bins 42 und 43 durchgeführt werden. Anschließend kann aus jedem der korrigierten k-Raum-Bins 46 und 47 jeweils ein korrigiertes Bin-MR-Bild 51 und 52 rekonstruiert R werden. Ferner kann das MR-Bild 50 aus den korrigierten Bin-MR-Bildern 51 und 52 erzeugt werden. Sofern nur eine Teilmenge aller k-Raum-Bins bewegungskorrigiert wird, kann das MR-Bild 50 aus den korrigierten Bin-MR-Bildern 51 und 52 und den übrigen, insbesondere nicht korrigierten, Bin-MR-Bildern (hier nicht gezeigt) erzeugt werden.

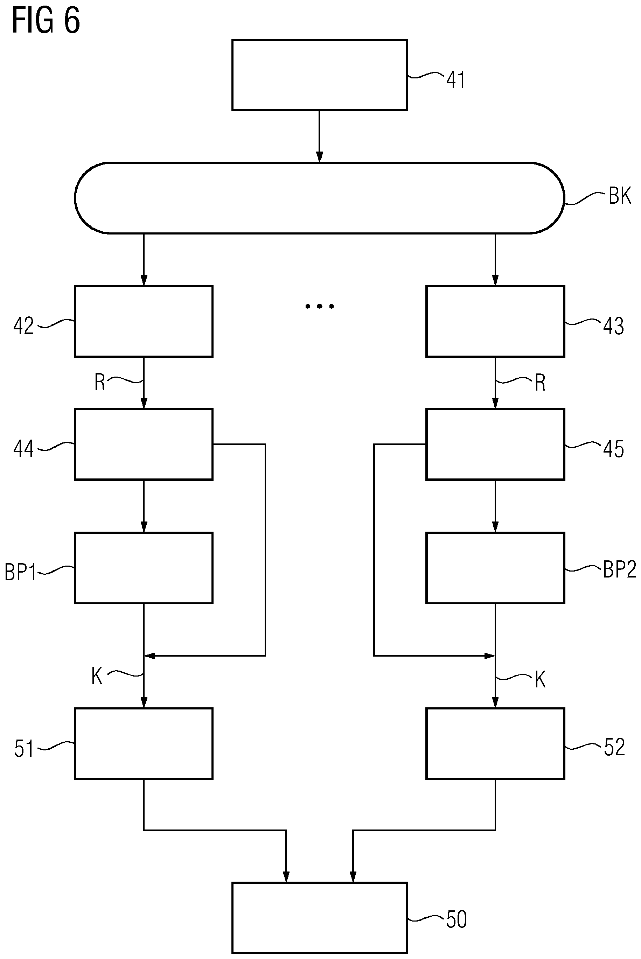

In Fig. 6 ist eine schematische Darstellung einer weiteren Ausführungsform des vorgeschlagenen Verfahrens abgebildet, wobei, insbesondere analog zur in Fig. 5 dargestellten Variante, zu jedem der rekonstruierten Bin-MR-Bilder 44 und 45 jeweils zumindest ein Bewegungskorrekturparameter BP1 und BPN bestimmt werden kann. Ferner kann mittels des jeweils zumindest einen Bewegungskorrekturparameters BP1 und BPN eine Korrektur K der Bin-MR-Bilder 44 und 45 durchgeführt werden. Hiernach kann das MR-Bild 50 aus den korrigierten Bin-MR-Bildern 51 und 52 erzeugt werden.

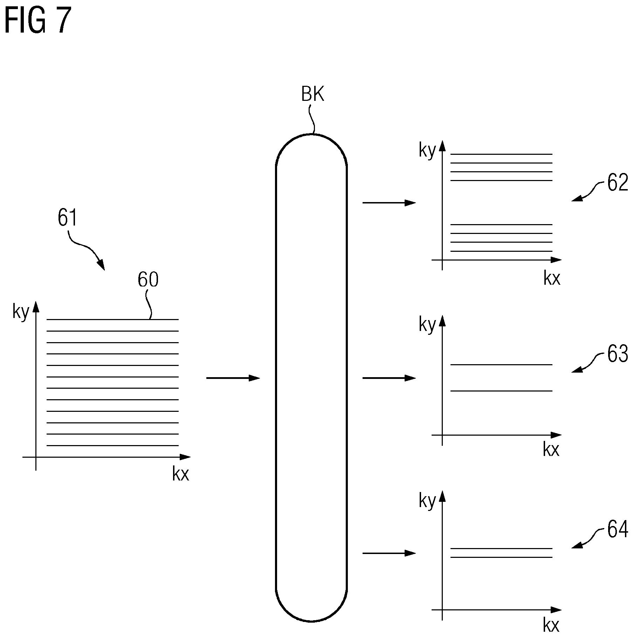

Fig. 7 zeigt eine schematische Darstellung einer Ausführungsform eines vorgeschlagenen Verfahrens mit einer Veranschaulichung der Aufteilung von k-Raum-Messdaten 41. Im hier dargestellten Ausführungsbeispiel sind die k-Raum-Messdaten 41 zweidimensional entlang einer Ausleserichtung kx und einer Phasenkodierrichtung ky des k-Raums aufgelöst. Ferner können die k-Raum-Messdaten 41 mehrere k-Raum-Abschnitte 60 umfassen. Dabei kann ein k-Raum-Abschnitte 60 beispielsweise durch eine k-Raum-Zeile gebildet werden. Anhand des Binning-Kriteriums BK können die k-Raum-Messdaten 41 beispielsweise in drei k-Raum-Bins 62, 63 und 64 aufgeteilt werden, wobei jeder der k-Raum-Bins zumindest einen k-Raum-Abschnitt umfasst.

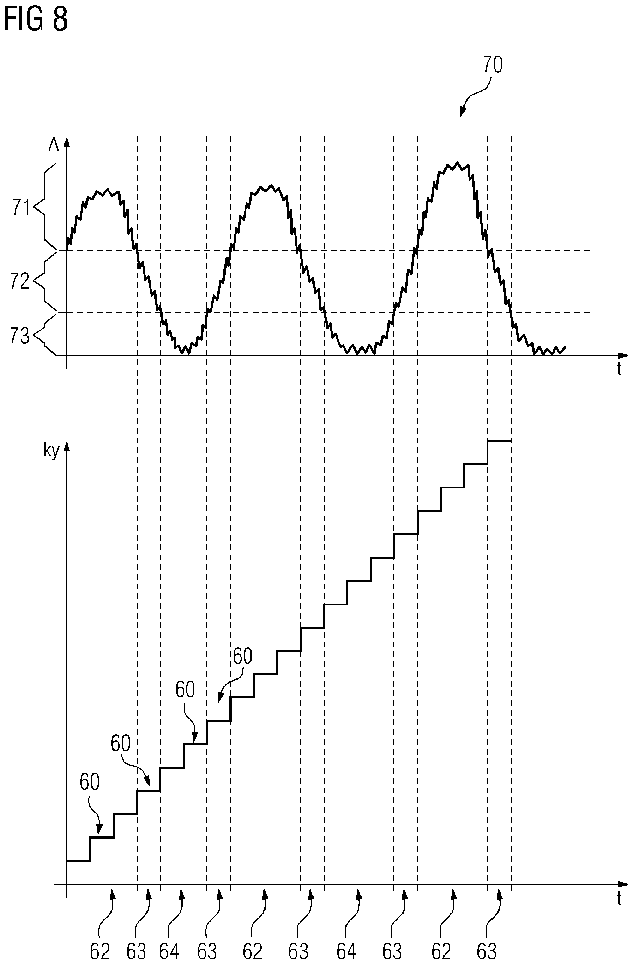

In Fig. 8 ist eine schematische Darstellung einer Variante des vorgeschlagenen Verfahrens abgebildet, wobei die Aufteilung der k-Raum-Messdaten 41 in die beispielhaften drei k-Raum-Bins 62, 63 und 64 in Abhängigkeit einer Phase 71, 72 und 73 eines physiologischen Signals 70 erfolgt. Das physiologische Signal 70 kann beispielsweise ein Atemsignal und/ oder ein Pulssignal eines Herzens des Untersuchungsobjekts 1 umfassen. Ferner kann das physiologische Signal 70 mehrere, insbesondere wiederkehrende, Phasen 71, 72 und 73 umfassen. Die Unterscheidung der Phasen 71, 72 und 73 kann beispielsweise in Abhängigkeit eines Amplitudenwertes A des physiologischen Signals 70 erfolgen.

Jedem in den k-Raum-Messdaten 41 enthaltenem k-Raum-Abschnitt 60 kann ein Aufnahmezeitpunkt zugeordnet werden. Ferner kann jedem Aufnahmezeitpunkt mittels des physiologischen Signals 70 eine Phase 71, 72 oder 73 des physiologischen Signals 70 zugeordnet werden. Zudem kann das Binning-Kriterium BK vorteilhafterweise eine Zuordnung der mehreren k-Raum-Abschnitte 60 zu den k-Raum-Bins 62, 63 und 63 in Abhängigkeit der zum jeweiligen Aufnahmezeitpunkt korrespondierenden Phase 71, 72 oder 73 des physiologischen Signals 70 umfassen. Im vorliegenden Ausführungsbeispiel erfolgt eine, insbesondere lineare und zweidimensionale, Abtastung des k-Raums. Während des zeitlichen Verlaufs des physiologischen Signals 70 schreitet die Abtastung der k-Raum-Abschnitte 60, hierbei beispielhaft jeweils eine k-Raum-Zeile umfassend, entlang der Phasenkodierrichtung ky fort.

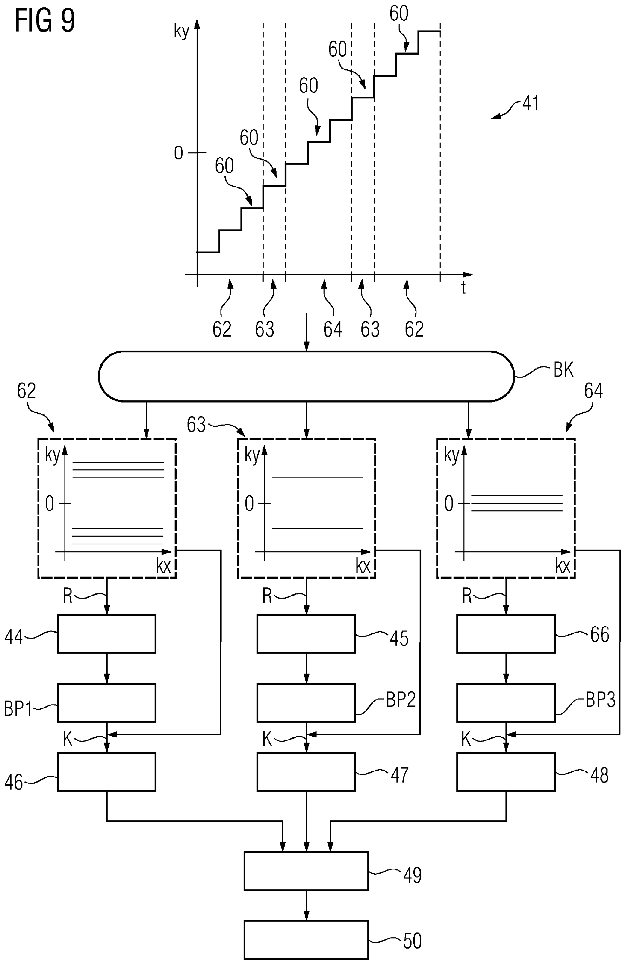

Fig. 9 zeigt eine schematische Darstellung eines Ablaufs der Verfahrensschritte einer Ausführungsform des vorgeschlagenen Verfahrens. Hierbei erfolgt die Aufteilung der k-Raum-Messdaten 41 mittels des Binning-Kriteriums BK insbesondere anlog zur in Fig. 8 abgebildeten Ausführungsform. Ferner entspricht der weiterhin abgebildete Ablauf des Verfahrens der in Fig. 4 gezeigten Variante. Dabei können die k-Raum-Messdaten 41 mehrere k-Raum-Abschnitte 60 umfassend, insbesondere mittels des Binning-Kriteriums BK, in beispielsweise drei k-Raum-Bins 62, 63 und 64 aufgeteilt werden. Jeder der k-Raum-Bins 62, 63 und 64 kann jeweils wiederum zumindest einen k-Raum-Abschnitt 60 umfassen. Nach Rekonstruktion R jeweils eines Bin-MR-Bildes 44, 45 und 66 aus jedem der k-Raum-Bins 62, 63 und 64, kann mittels der Bin-MR-Bilder 44, 45 und 66 jeweils zumindest ein Bewegungskorrekturparameter BP1, BP2 und BP3 bestimmt werden. Die Bestimmung der Bewegungskorrekturparameter BP1, BP2 und BP3 kann beispielsweise mittels einer Registrierung der rekonstruierten Bin-MR-Bilder 44, 45 und 66 zueinander erfolgen.

Hiernach kann eine Korrektur K der k-Raum-Bins 62, 63 und 64 mittels der Bewegungskorrekturparameter BP1, BP2 und BP3 durchgeführt werden. Anschließend können korrigierte k-Raum-Bins 46, 47 und 48 zu korrigierten k-Raum-Messdaten 49 zusammengesetzt werden, wobei das MR-Bild 50 aus den korrigierten k-Raum-Messdaten 49 rekonstruiert werden kann.

Die Korrektur der k-Raum-Bins 62, 63 und 64 kann vorteilhafterweise eine Anwendung einer, insbesondere linearen, Phasenrampe und/oder eine Neurasterung umfassen.

Anhand der mehreren Bewegungskorrekturparameter BP1, BP2 und BP3 kann vorteilhafterweise ein Bewegungssignal bestimmt werden. Dabei kann jedem Aufnahmezeitpunkt eines k-Raum-Abschnitts 60 ein Bewegungskorrekturparameter BP1, BP2 oder BP3 zugeordnet werden, der anhand des aus dem korrespondierenden k-Raum-Bin 62, 63 oder 64 rekonstruierten Bin-MR-Bildes 44, 45 oder 66 bestimmt wurde. Das Bewegungssignal kann durch den zeitlichen Verlauf der den Aufnahmezeitpunkten zugeordneten Bewegungskorrekturparameter BP1, BP2 und BP3 gebildet werden. Dabei kann das Bewegungssignal beispielsweise einem physiologischen Signal 70 des Untersuchungsobjekts 1 entsprechen, beispielsweise einem Atemsignal und/oder eine Pulssignal des Herzens.

Die in den beschriebenen Figuren enthaltenen schematischen Darstellungen bilden keinerlei Maßstab oder Größenverhältnis ab.

Es wird abschließend noch einmal darauf hingewiesen, dass es sich bei den vorhergehend detailliert beschriebenen Verfahren sowie bei den dargestellten Vorrichtungen lediglich um Ausführungsbeispiele handelt, welche vom Fachmann in verschiedenster Weise modifiziert werden können, ohne den Schutzumfang der Erfindung zu verlassen, wobei der Schutzumfang durch die beigefügten Ansprüche definiert ist. Weiterhin schließt die Verwendung der unbestimmten Artikel "ein" bzw. "eine" nicht aus, dass die betreffenden Merkmale auch mehrfach vorhanden sein können. Ebenso schließt der Begriff "Einheit" nicht aus, dass die betreffenden Komponenten aus mehreren zusammenwirkenden Teil-Komponenten bestehen, die gegebenenfalls auch räumlich verteilt sein können.

## Patentansprüche

1. Verfahren zur Verbesserung der Qualität von MR-Bildern, umfassend:
- Erfassen von k-Raum-Messdaten (41) mehrere k-Raum-Abschnitte (60) umfassend von einem Untersuchungsobjekt (1) mittels einer Magnetresonanzanlage (7),
- Aufteilen der k-Raum-Messdaten (41) in zumindest zwei k-Raum-Bins (42,43) jeweils zumindest einen k-Raum-Abschnitt (60) umfassend,
- Rekonstruieren (R) jeweils eines Bin-MR-Bildes (44,45) aus jedem der k-Raum-Bins (42,43),
- Bestimmen zumindest eines Bewegungskorrekturparameters (BP) anhand der rekonstruierten Bin-MR-Bilder (44,45),
- Durchführen einer Korrektur (K) zumindest eines k-Raum-Bins (42,43) mittels des zumindest einen Bewegungskorrekturparameters (BP), **dadurch gekennzeichnet, dass** das Verfahren die folgenden Schritte umfasst:
- Rekonstruktion jeweils eines korrigierten Bin-MR-Bildes (51,52) aus jedem der korrigierten k-Raum-Bins (46,47),
- Erzeugen eines MR-Bildes (50) mittels des zumindest einen Bewegungskorrekturparameters (BP),
wobei das MR-Bild (50) aus den korrigierten Bin-MR-Bildern (51,52) und den übrigen Bin-MR-Bildern erzeugt wird.

2. Verfahren nach Anspruch 1, wobei die Korrektur (K) des zumindest einen k-Raum-Bins (42,43) eine Anwendung einer, insbesondere linearen, Phasenrampe und/oder einer Rotationstransformation und/oder eine Neurasterung umfasst.

3. Verfahren nach Anspruch 1 oder 2, **dadurch gekennzeichnet, dass** die Aufteilung der k-Raum-Messdaten (41) in die zumindest zwei k-Raum-Bins (42,43) in Abhängigkeit einer Phase (71,72,73) eines physiologischen Signals (70) erfolgt.

4. Verfahren nach einem der vorangehenden Ansprüche, **dadurch gekennzeichnet, dass** zu jedem der rekonstruierten Bin-MR-Bilder (44,45) jeweils zumindest ein Bewegungskorrekturparameter (BP1, BPN) bestimmt wird.

5. Verfahren nach Anspruch 4, **dadurch gekennzeichnet, dass** ein Bewegungssignal anhand der mehreren Bewegungskorrekturparameter (BP1, BPN) bestimmt wird.

6. Verfahren nach Anspruch 5, **dadurch gekennzeichnet, dass** das Bewegungssignal einem physiologischen Signal (70) entspricht.

7. Verfahren nach einem der vorangehenden Ansprüche, **dadurch gekennzeichnet, dass** der zumindest eine Bewegungskorrekturparameter (BP1, BPN) mittels einer Registrierung der rekonstruierten Bin-MR-Bilder (44,45) zueinander bestimmt wird.

8. Verfahren nach einem der vorangehenden Ansprüche, **dadurch gekennzeichnet, dass** die Rekonstruktion (R) der Bin-MR-Bilder (44,45) aus jedem der k-Raum-Bins (42,43) eine Anwendung eines Verfahrens zur Rekonstruktion dünnbesetzter k-Raum-Abtastungen umfasst.

9. Verfahren nach einem der vorangehenden Ansprüche, **dadurch gekennzeichnet, dass** die k-Raum-Messdaten (41) in eine Anzahl an k-Raum-Bins (42,43) aufgeteilt werden, wobei die Anzahl in Abhängigkeit einer räumlichen Auflösung und/oder eines Akquisitionsprotokolls und/oder einer Navigatormessung bestimmt wird.

10. Magnetresonanzanlage (7) ausgebildet, ein Verfahren zur Verbesserung der Qualität von Magnetresonanzabbildungen gemäß einem der Ansprüche 1 bis 9 durchzuführen, wobei die Magnetresonanzanlage (7) eine HF-Verarbeitungseinheit (21), eine Gradientensteuereinheit (22), eine Sequenzsteuereinheit und eine Verarbeitungseinheit (20) umfasst, und wobei die Magnetresonanzanlage (7) derart ausgestaltet ist, um mittels der HF-Verarbeitungseinheit (21), der Gradientensteuereinheit (22), der Sequenzsteuereinheit und der Verarbeitungseinheit (20) zumindest ein MR-Bild (50) zu erzeugen.

11. Computerprogrammprodukt, welches ein Programm umfasst und direkt in einen Speicher einer programmierbaren Recheneinheit einer Verarbeitungseinheit (20) einer Magnetresonanzanlage nach Anspruch 10 ladbar ist, mit Programmmitteln, um ein Verfahren nach einem der Ansprüche 1 bis 9 auszuführen, wenn das Programm in der Recheneinheit der Verarbeitungseinheit (20) ausgeführt wird.

## Claims

1. Method for improving the quality of MR images, comprising:
- capturing k-space measurement data (41) of a plurality of k-space portions (60) comprising an examination object (1) by means of a magnetic resonance system (7),
- distributing the k-space measurement data (41) into at least two k-space bins (42, 43), each comprising at least one k-space portion (60),
- reconstructing (R) a bin MR image (44, 45) from each of the k-space bins (42, 43) in each case,
- determining at least one motion correction parameter (BP) using the reconstructed bin MR images (44, 45),
- carrying out a correction (K) of at least one k-space bin (42, 43) by means of the at least one motion correction parameter (BP), **characterised in that** the method comprises the following steps:
- reconstructing a corrected bin MR image (51, 52) from each of the corrected k-space bins (46, 47) in each case,
- generating an MR image (50) by means of the at least one motion correction parameter (BP),
wherein the MR image (50) is generated from the corrected bin MR images (51, 52) and the remaining bin MR images.

2. Method according to claim 1, wherein the correction (K) of the at least one k-space bin (42, 43) comprises an application of an in particular linear phase ramp and/or a rotation transformation and/or a rescan.

3. Method according to claim 1 or 2, **characterised in that** the distribution of the k-space measurement data (41) into the at least two k-space bins (42, 43) takes place as a function of a phase (71, 72, 73) of a physiological signal (70).

4. Method according to one of the preceding claims, **characterised in that** at least one motion correction parameter (BP1, BPN) is determined in each case for each of the reconstructed bin MR images (44, 45).

5. Method according to claim 4, **characterised in that** a motion signal is determined based on the plurality of motion correction parameters (BP1, BPN).

6. Method according to claim 5, **characterised in that** the motion signal corresponds to a physiological signal (70).

7. Method according to one of the preceding claims, **characterised in that** the at least one motion correction parameter (BP1, BPN) is determined by means of a registration of the reconstructed bin MR images (44, 45) to one another.

8. Method according to one of the preceding claims, **characterised in that** the reconstruction (R) of the bin MR images (44, 45) from each of the k-space bins (42, 43) comprises an application of a method for reconstructing sparse k-space scans.

9. Method according to one of the preceding claims, **characterised in that** the k-space measurement data (41) is divided into a number of k-space bins (42, 43), wherein the number is determined depending on a spatial resolution and/or an acquisition protocol and/or a navigator measurement.

10. Magnetic resonance system (7) designed to carry out a method for improving the quality of magnetic resonance images according to one of claims 1 to 9, wherein the magnetic resonance system (7) comprises an RF processing unit (21), a gradient control unit (22), a sequence control unit and a processing unit (20), and wherein the magnetic resonance system (7) is designed so as to generate at least one MR image (50) by means of the RF processing unit (21), the gradient control unit (22), the sequence control unit and the processing unit (20).

11. Computer program product, which comprises a program and can be loaded directly into a memory of a programmable computing unit of a processing unit (20) of a magnetic resonance system according to claim 10, with program means to carry out a method according to one of claims 1 to 9 when the program is executed in the computing unit of the processing unit (20).

## Revendications

1. Procédé d'amélioration de la qualité d'images RM, comprenant :
- saisie de données (41) de mesure d'espace k comprenant plusieurs parties (60) d'espace k d'un objet (1) à examiner au moyen d'une installation (7) de résonnance magnétique,
- subdivision des données (41) de mesure d'espace k en au moins deux segments (42, 43) d'espace k comprenant respectivement au moins une partie (60) d'espace k,
- reconstruction (R) respectivement d'une image (44, 45) RM de segment à partir de chacun des segments (42, 43) d'espace k,
- détermination d'au moins un paramètre (BP) de correction de mouvement à l'aide des images (44, 45) RM de segment reconstruites,
- mise en œuvre d'une correction (K) d'au moins un segment (42, 43) d'espace k au moyen du au moins un paramètre (BP) de correction de mouvement, **caractérisé en ce que** le procédé comprend les stades suivants :
- reconstruction respectivement d'une image (51, 52) RM de segment corrigée à partir de chacun des segments (46, 47) d'espace k corrigés,
- production d'une image (50) RM au moyen du au moins un paramètre (BP) de correction de mouvement,
dans lequel on produit l'image (50) RM à partir des images (51, 52) RM de segment corrigées et des autres images RM de segment.

2. Procédé suivant la revendication 1, dans lequel la correction (K) du au moins un segment (42, 43) d'espace k comprend une application d'une rampe de phase, en particulier linéaire, et/ou d'une transformation de rotation et/ou d'un nouveau tramage.

3. Procédé suivant la revendication 1 ou 2, **caractérisé en ce que** la subdivision des données (41) de mesure d'espace k en les au moins deux segments (42, 43) d'espace k s'effectue en fonction d'une phase (71, 72, 73) d'un signal (70) physiologique.

4. Procédé suivant l'une des revendications précédentes, **caractérisé en ce que** l'on détermine, pour chacune des images (44, 45) RM de segment reconstruites, au moins un paramètre (BP1, BPN) de correction de mouvement.

5. Procédé suivant la revendication 4, **caractérisé en ce que** l'on détermine un signal de mouvement à l'aide des plusieurs paramètres (BP1, BPN) de correction de mouvement.

6. Procédé suivant la revendication 5, **caractérisé en ce que** le signal de mouvement correspond à un signal (70) physiologique.

7. Procédé suivant l'une des revendications précédentes, **caractérisé en ce que** l'on détermine le au moins un paramètre (BP1, BPN) de correction de mouvement au moyen d'une mise en correspondance entre elles des images (44, 45) RM de segment reconstruites.

8. Procédé suivant l'une des revendications précédentes, **caractérisé en ce que** la reconstruction (R) des images (44, 45) RM de segment à partir de chacun des segments (42, 43) d'espace k comprend une application d'un procédé de reconstruction de balayage d'espace k creux.

9. Procédé suivant l'une des revendications précédentes, **caractérisé en ce que** l'on répartit des données (41) de mesure d'espace k en un certain nombre de segments (42, 43) d'espace k, dans lequel on détermine le nombre en fonction d'une résolution spatiale et/ou d'un protocole d'acquisition et/ou d'une mesure de navigateur.

10. Installation (7) de résonnance magnétique constituée pour effectuer un procédé d'amélioration de la qualité de représentations de résonnance magnétique suivant l'une des revendications 1 à 9, dans lequel l'installation (7) de résonnance magnétique comprend une unité (21) de traitement HF, une unité (22) de commande de gradient, une unité de commande de séquence et une unité (20) de traitement, et dans laquelle l'installation (7) de résonnance magnétique est conformée pour produire au moins une image (50) RM à l'aide de l'unité (21) de traitement HF, de l'unité (22) de commande de gradient et de l'unité (20) de traitement.

11. Produit de programme d'ordinateur, qui comprend un programme et qui peut être chargé directement dans la mémoire d'une unité informatique programmable d'une unité (20) de traitement d'une installation de résonnance magnétique suivant la revendication 10, comprenant des moyens de programme pour exécuter un procédé suivant l'une des revendications 1 à 9, lorsque le programme est réalisé dans l'unité informatique de l'unité (20) de traitement.
